# FASCICULE DE BREVET EUROPEEN

(11) **EP 3 985 817 B1**
(45) Date de publication et mention de la délivrance du brevet: **15.03.2023**
(21) Numéro de dépôt: 21198184.0
(22) Date de dépôt: 22.09.2021
(51) Int. Cl.: H02G 15/013, H02G 3/22, G02B 6/44

(54) **OBTURATEUR POUR BOITIER DESTINE A ACCUEILLIR AU MOINS UNE EXTREMITE DE CABLE ET BOITIER CORRESPONDANT**
VERSCHLUSS FÜR EIN GEHÄUSE ZUR AUFNAHME VON MINDESTENS EINEM KABELENDE UND ENTSPRECHENDES GEHÄUSE
SHUTTER FOR HOUSING INTENDED FOR RECEIVING AT LEAST ONE END OF A CABLE AND CORRESPONDING HOUSING

(30) Priorité: 19.10.2020 FR 2010728
(43) Date de publication de la demande: 20.04.2022
(73) Titulaire: Sagemcom Energy & Telecom SAS, 92500 Rueil-Malmaison (FR)
(72) Inventeur: ROLLAND, Patrick, 92500 RUEIL MALMAISON (FR)
(74) Mandataire: Decorchemont, Audrey Véronique Christèle

(56) Documents cités:
- EP-A1- 3 512 045
- WO-A1-2014/139102
- DE-B3- 10 313 285
- US-A- 5 886 300

## Description

L'invention concerne un obturateur pour boîtier destiné à accueillir au moins une extrémité de câble.

L'invention concerne également un boîtier équipé d'un tel obturateur.

### ARRIERE PLAN DE L'INVENTION

Les boîtiers destinés à accueillir au moins une extrémité de câble, tels que des compteurs électriques, peuvent être agencés à l'extérieur des habitations.

De tels boîtiers sont donc soumis à des environnements contraignants. Ainsi en plus de contraintes météorologiques (vent, pluie, humidité, brouillard salin ...), ces boîtiers sont aussi exposés aux matières organiques (telles que de la poussière) ou bien encore aux attaques de nuisibles de type rongeurs ou insectes. En particulier, les insectes, de par leurs petites tailles, arrivent à pénétrer dans les boîtiers via le ou les orifices à travers lesquels s'étendent en service les extrémités de câbles causant des dégâts importants directement à l'intérieur des boîtiers.

Ceci est particulièrement préjudiciable dans le cas des compteurs électriques pour lesquels les dégâts causés par les nuisibles peuvent aller jusqu'à entraîner un embrasement du compteur.

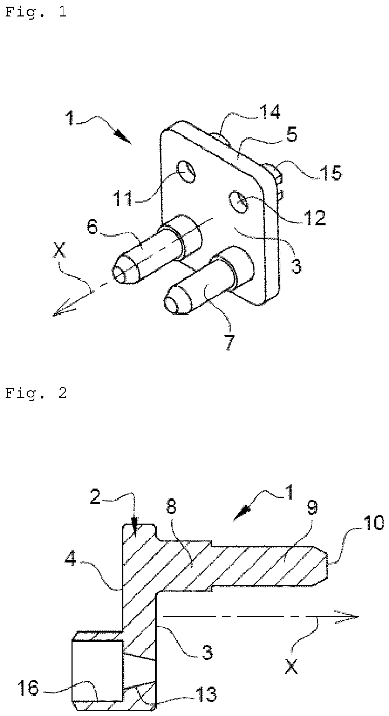

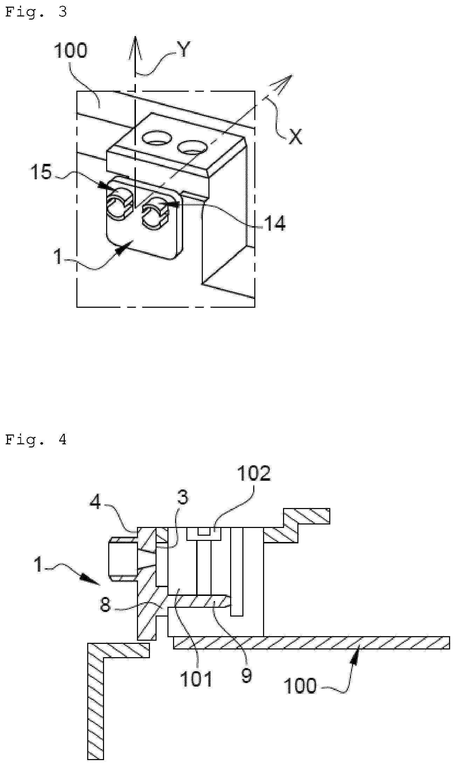

Le document EP 3 512 045 décrit une prise électrique, similaire à une prise murale classique que l'on peut trouver dans un logement de particulier. Le boitier 2 de la prise électrique comporte un cache 5 qui est mobile en translation dans le boitier entre une position encastrée (figure 1B), et une position étendue (figure 1A). Lorsque que le cache 5 est en position encastrée, il y a contact électrique entre une prise électrique mâle et les terminaux de la prise électrique. Au contraire, lorsque le cache 5 est en position étendue, il n'y a pas contact électrique. Toutefois, peu importe la position du cache 5, il donne toujours accès à l'intérieur du boitier 2 via ses orifices 5.1 et 5.3.Le document WO 2014/139102 divulgue un port d'entrée (100, 500, 600) permettant d'assurer une étanchéité lorsqu'une extrémité de ladite liaison filaire entre dans un boitier d'interconnexion ou un terminal. Le port d'entrée, présente une section interne creuse (111, 511) pour recevoir une liaison filaire (comme visible à la figure 3). Un bouchon 121 peut venir bloquer temporairement l'une des extrémités du port d'entrée.

### OBJET DE L'INVENTION

Un but de l'invention est de proposer une solution permettant de mieux protéger de l'environnement extérieur un boîtier destiné à accueillir au moins une extrémité de câble.

### RESUME DE L'INVENTION

En vue de la réalisation de ce but, on propose, selon l'invention, un obturateur selon la revendication 1.

De la sorte, avec une seule pièce qu'est l'obturateur, l'invention permet, selon le sens d'utilisation de ladite pièce, soit de boucher l'orifice soit d'en autoriser l'accès pour le branchement d'une extrémité de câble au boitier.

L'invention permet simplement de mieux protéger un boitier de l'environnement extérieur que ce soit vis-à-vis de contraintes météorologiques, de matière organique, de nuisibles ... L'invention permet notamment de limiter l'accès à l'intérieur du boîtier par des nuisibles, en particulier des insectes tels que par exemple des fourmis et/ou des limaces.

De façon avantageuse, l'invention rend également plus sûr le boitier ainsi équipé vis-à-vis d'un utilisateur ou d'un opérateur puisqu'il limite l'accès à l'intérieur du boitier.

Par ailleurs un boitier déjà muni de l'invention peut être livré directement sur site, l'invention étant dans son premier sens d'utilisation. Un premier opérateur peut alors équiper le site dudit boitier. Un deuxième opérateur venant ultérieurement sur site n'aura qu'à modifier le sens d'utilisation de l'invention pour effectuer le raccordement du boîtier. L'invention est donc aisée à utiliser.

On note également que l'invention peut avantageusement être utilisée avec des boîtiers déjà commercialisés et/ou des boîtiers déjà installés sur site. L'invention peut ainsi être utilisée sur un boitier sans pour autant nécessiter une modification de la structure, de la forme, des dimensions etc. dudit boitier. En particulier, l'invention peut être utilisée sans avoir à agrandir l'orifice d'accès du boitier.

Optionnellement la broche est venue de matière avec une base de l'obturateur.

Optionnellement la broche s'étend à partir d'un des coins de l'obturateur et/ou l'ouverture est ménagée dans l'un des coins de l'obturateur.

Optionnellement la broche s'étend à partir d'un premier coin de l'obturateur et l'ouverture est ménagée dans un deuxième coin de l'obturateur différent du premier coin. Optionnellement la broche comporte au moins deux tronçons dont l'un est d'un diamètre supérieur à l'autre. Optionnellement le tronçon de plus gros diamètre est conformé pour présenter un diamètre supérieur à celui de l'orifice d'accès associé.

Optionnellement l'ouverture est conformée en un tronc de cône se rétrécissant en direction d'une face de l'obturateur portant la broche.

Optionnellement au moins un tronçon de l'ouverture présente un diamètre supérieur à celui d'une extrémité de câble. L'obturateur comporte une bride associée à l'ouverture. Optionnellement la bride est ouverte sur au moins une partie de sa périphérie.

Optionnellement la bride est conformée pour présenter, au moins à son extrémité libre, un diamètre supérieur à celui de l'orifice d'accès.

Optionnellement l'obturateur comporte au moins :
- deux broches destinées à, dans un premier sens d'utilisation de l'obturateur, boucher l'un respectifs des orifices d'accès à l'intérieur du boîtier, et
- deux ouvertures destinées à, dans un deuxième sens d'utilisation de l'obturateur, coopérer avec les orifices d'accès pour permettre à au moins une extrémité de câble de s'étendre en service à travers l'une des ouvertures et l'orifice associé afin de pénétrer à l'intérieur du boîtier.

L'invention concerne également un boitier selon la revendication 12.

Optionnellement le boîtier est un compteur électrique. Optionnellement le boitier comporte au moins un moyen de verrouillage de l'âme conductrice dans le boitier lorsque l'obturateur est dans sa deuxième position et qu'une extrémité de câble est raccordé au boitier, l'obturateur étant conformé de sorte que dans sa première position le moyen de verrouillage coopère avec la broche pour maintenir l'obturateur en position.

L'invention concerne également un boîtier comprenant un tel obturateur.

### BREVE DESCRIPTION DES DESSINS

L'invention sera mieux comprise à la lumière de la description qui suit en référence aux figures annexées parmi lesquelles :
[Fig.1] la figure 1 est une vue en perspective d'un obturateur selon un mode de réalisation particulier de l'invention,
[Fig.2] la figure 2 est une vue en coupe longitudinale de l'obturateur illustré à la figure 1,
[Fig.3] la figure 3 est une vue schématique de l'obturateur illustré à la figure 1 en position sur un boitier selon un premier sens d'utilisation,
[Fig.4] la figure 4 est une vue en coupe longitudinale schématique du boitier illustré à la figure 3,
[Fig.5] la figure 5 est une vue schématique de l'obturateur en position sur le boitier illustré à la figure 3 selon un deuxième sens d'utilisation, des extrémités de câbles étant insérées dans l'obturateur et le boitier, les gaines isolantes desdites extrémités étant représentées en pointillés,
[Fig.6] la figure 6 est une vue en coupe longitudinale schématique du boitier illustré à la figure 5.

### DESCRIPTION DETAILLEE DE L'INVENTION

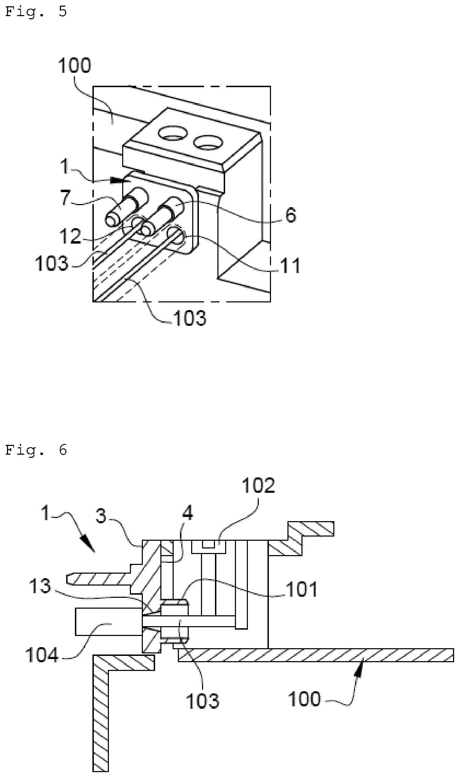

En référence aux figures 1 à 2, l'obturateur 1 selon un mode de réalisation particulier de l'invention est ici destiné à être agencé sur un boitier 100 illustré aux figures 3 à 6.

L'obturateur 1 comporte une base 2. La base 2 est ici plate. La base 2 comprend ainsi une première face principale 3, une deuxième face principale 4 et au moins une face formant un pourtour 5 de la base et reliant les deux faces principales 3, 4 entre elles.

Les deux faces principales 3, 4 sont ici planes et parallèles entre elles. Les deux faces principales 3, 4 sont identiques entre elles. Les deux faces principales 3, 4 ont globalement une forme carré ou rectangulaires. Plus précisément, les deux faces principales 3, 4 ont une forme carré à coins arrondis ou rectangulaire à coins arrondis. Le pourtour 5 est de faible épaisseur c'est-à-dire d'épaisseur moins importante que la largeur des faces principales 3, 4. Le pourtour 5 est ici formé d'une seule face présentant quatre portions rectilignes reliées deux à deux par un congé, chaque congé étant associé à deux coins arrondis en regard des faces principales 3, 4.

L'obturateur 1 comporte par ailleurs au moins une broche s'étendant à partir de la première face principale 3, la broche étant destinée à boucher un orifice d'accès à l'intérieur du boîtier 100.

De préférence, l'obturateur 1 comporte autant de broches qu'il y a d'orifices d'accès à l'intérieur du boitier 100, orifices d'accès adjacents les uns des autres.

Un même obturateur 1 peut ainsi servir à boucher plusieurs orifices d'accès à l'intérieur du boitier 100.

Dans le cas présent, l'obturateur 1 est destiné à être agencé au niveau d'un bornier du boitier 100, le bornier comprenant N orifices d'accès i.e. N orifices de câblage. L'obturateur 1 comprend donc de préférence N broches correspondantes.

Dans le cas présent, N est égal à deux.

L'obturateur 1 comprend donc deux broches 6, 7 qui sont bien entendu agencées de sorte à apte à être insérées chacune dans l'un des orifices d'accès du boitier 100. A cet effet, les deux broches 6, 7 sont ici adjacentes et sensiblement au même niveau.

Les deux broches 6, 7 sont identiques entre elles.

Les deux broches 6, 7 s'étendent toutes deux à partir de la première face principale 3 en direction opposée à la deuxième face principale 4.

Chaque broche 6, 7 s'étend rectilignement parallèlement à un premier axe X qui est normal au plan dans lequel s'étend la première face principale 3.

La première broche 6 est ici agencée de sorte à s'étendre à partir d'un premier coin de la première face 3 et la deuxième broche 7 à partir d'un deuxième coin de la première face 3, le premier coin et le deuxième coin étant adjacents (il ne s'agit donc pas des coins agencés en diagonale sur la première face 3).

Dans le cas présent, chaque broche 6, 7 comprend deux tronçons : un tronçon d'attache 8 à la première face principale 3 et un tronçon de solidarisation 9 de l'obturateur 1 au boitier 100, le tronçon de solidarisation 9 s'étendant dans le prolongement du tronçon d'attache 8. Chaque broche 6, 7 est ici conformée sous la forme d'un solide de révolution. Le tronçon d'attache 8 est typiquement un cylindre de révolution et le tronçon de solidarisation 9 un cylindre de révolution de diamètre inférieur à celui du tronçon d'attache 8. Optionnellement, le tronçon de solidarisation 9 présente une extrémité libre 10 en tronc de cône, le reste du tronçon de solidarisation 9 étant conformé en cylindre de révolution. Le tronçon d'attache 8 et le tronçon de solidarisation 9 sont par ailleurs coaxiaux.

Selon un mode de réalisation préféré, le tronçon d'attache 8 est d'un diamètre supérieur au diamètre de l'orifice d'accès associé. Le tronçon de solidarisation 9 est bien entendu d'un diamètre inférieur ou égal à celui du diamètre de l'orifice d'accès associé.

Les deux broches 6, 7 sont ici venues de matière avec la base 2.

L'obturateur 1 est donc d'une seule pièce.

Par ailleurs, l'obturateur 1 comporte au moins une ouverture destinée à coopérer avec l'orifice d'accès pour permettre à au moins une extrémité de câble de s'étendre en service à travers l'ouverture 11 et l'orifice d'accès afin de pénétrer à l'intérieur du boîtier 100.

De préférence, l'obturateur 1 comporte autant d'ouvertures qu'il y a d'orifices d'accès à l'intérieur du boitier 100 adjacents les uns des autres.

Un même obturateur 1 peut ainsi servir à permettre l'accès à l'intérieur du boitier 100 via plusieurs orifices d'accès.

De préférence l'obturateur 1 comporte autant d'ouvertures qu'il ne comporte de broches.

Dans le cas présent, l'obturateur 1 étant destiné à être agencé au niveau d'un bornier du boitier 100, le bornier comprenant N orifices d'accès i.e. N orifices de câblage, l'obturateur 1 comprend donc de préférence N ouvertures correspondantes. Comme déjà indiqué, N est strictement égal à deux dans le cas présent.

L'obturateur 1 comprend donc deux ouvertures 11, 12 qui sont bien entendu agencées de sorte à apte à coopérer chacune avec l'un respectif des orifices d'accès du boitier 100. A cet effet, les deux ouvertures 11, 12 sont ici adjacentes et sensiblement au même niveau.

Les deux ouvertures 11, 12 sont identiques entre elles.

Chaque ouverture 11, 12 s'étend ici dans la base 2 de sorte à déboucher à une première extrémité sur la première face principale 3 et à une deuxième extrémité sur la deuxième face principale 4.

Chaque ouverture 11, 12 s'étend rectilignement parallèlement au premier axe X.

La première ouverture 11 est ici agencée de sorte à s'étendre entre le troisième coin de la première face principale 3 et le troisième coin correspondant de la deuxième face principale 4. La deuxième ouverture 12 est ici agencée de sorte à s'étendre entre le quatrième coin de la première face principale 3 et le quatrième coin de la deuxième face principale 4. Les deux coins associés aux deux ouvertures 11, 12 sont donc adjacentes (il ne s'agit donc pas des coins agencés en diagonale sur la base 2). Par ailleurs les deux coins associés aux deux ouvertures 11, 12 sont différents des deux coins associés aux deux broches 6, 7 ce qui va permettre de pouvoir utiliser l'obturateur 1 selon deux sens d'utilisations différents comme nous allons le voir par la suite.

Selon un mode de réalisation particulier, chaque ouverture 11, 12 est conformée en un solide de révolution. De préférence, chaque ouverture 11, 12 est conformée en tronc de cône 13. Chaque ouverture 11, 12 est par ailleurs ménagée dans la base 2 de sorte que la petite base du tronc de cône débouche sur la première face principale 3 et que la grande base du tronc de cône débouche sur la deuxième face principale 4.

La droite génératrice de chaque tronc de cône 13 est bien entendu parallèle au premier axe X.

Selon un mode de réalisation particulier l'obturateur 1 comporte une bride associée à chaque ouverture. L'obturateur comprend donc ici deux brides 14, 15 qui sont dans le cas présent identiques entre elles.

Les deux brides 14, 15 s'étendent toutes deux à partir de la deuxième face principale 4 en direction opposée à la première face principale 3.

Chaque bride 14, 15 s'étend rectilignement parallèlement au premier axe X.

La première bride 14 est agencée de sorte à s'étendre dans le prolongement de la première ouverture 11 et la deuxième bride 15 est agencée de sorte à s'étendre dans le prolongement de la deuxième ouverture 12.

Chaque bride 14, 15 est conformée sous la forme d'un solide de révolution. Chaque bride 14, 15 est ainsi agencée de sorte à s'étendre coaxialement à l'ouverture associée. Selon un mode de réalisation préféré, chaque bride 14, 15 est d'un diamètre supérieur au diamètre de l'orifice d'accès associé.

Chaque bride 14, 15 comporte un trou 16 ménagé dans la bride de sorte à déboucher à une première extrémité sur la deuxième face principale 4 à niveau de l'ouverture associée et à une deuxième extrémité vers l'extérieur de la bride associée et de l'obturateur 1. Chaque trou 16 s'étend rectilignement parallèlement au premier axe X. Par ailleurs, chaque trou 16 s'étend coaxialement à l'ouverture associée. Chaque trou 16 présente un diamètre plus important que l'ouverture associée même au niveau de la grande base du tronc de cône 13 de ladite ouverture. Chaque bride 14, 15 est ici constituée de deux parties indépendantes à savoir une partie supérieure et une partie inférieure agencées de manière diamétralement opposées vis-à-vis du trou associé et de l'ouverture associée. Chaque bride 14, 15 est donc ouverte latéralement sur ses deux côtés.

Chaque partie comporte une zone centrale en arc de cercle délimitée à ses deux extrémités par des flancs. Lesdits flancs d'une même partie s'étendent chacun rectilignement parallèlement entre eux et à un deuxième axe Y qui est orthogonal au premier axe X, le deuxième axe Y s'étendant par ailleurs parallèlement à l'un des côtés de la base 2. Chaque partie comportant deux flancs, chaque bride en comporte quatre qui s'étendent tous parallèlement entre eux (et aux flancs de l'autre bride) selon le deuxième axe Y.

Les brides 14, 15, présentent une longueur (selon le premier axe X) qui est de préférence égale à celle des tronçons d'attache 8 des broches 6, 7.

Les deux brides 14, 15 sont ici venues de matière avec la base 2. L'obturateur 1 est donc d'une seule pièce.

Au moins les broches 6, 7 et les deux ouvertures 11, 12 sont dans une matière électriquement isolante. De préférence, tout l'obturateur est dans une matière électriquement isolante.

Dans tous les cas, la matière électriquement isolante peut être par exemple une matière plastique.

Dans tous les cas, la matière électriquement isolante peut être par exemple du polycarbonate (PC), du polystyrène (PS), de l'acrylonitrile butadiène styrène (ABS), du PC-ABS ...

On va à présent décrire une mise en œuvre particulière de l'obturateur.

Comme visible aux figures 3 et 4, avant tout raccordement d'extrémité de câble, l'obturateur 1 est agencé relativement au boitier 100 selon un premier sens d'utilisation visant à en boucher les orifices d'accès 101. A cet effet, chaque broche 6, 7 est agencée de sorte à s'étendre à travers l'un respectif des deux orifices d'accès 101 du boitier. La première face principale 3 de l'obturateur 1 est alors tournée vers le boitier 100 et la deuxième face principale 4 vers l'extérieur du boitier 100. De la sorte, on protège très bien le boitier 100 de l'environnement extérieur.

De préférence, seuls les tronçons de solidarisation 9 s'étendent à travers les orifices d'accès 101. Les tronçons d'attache 8 viennent au contraire en butée contre le boitier 100.

Les tronçons d'attache 8 bordent ainsi extérieurement les orifices d'accès 101.

Ceci permet encore davantage de protéger le boitier 100 de l'environnement extérieur.

De façon avantageuse, l'obturateur 1 est maintenu dans sa première position vis-à-vis du boitier 100 par l'intermédiaire de moyens de verrouillage du boitier pour le verrouillage des extrémités de câble dans le boitier 100. Par exemple les moyens de verrouillage comportent des vis de maintien 102 s'étendant toutes dans le boitier selon une direction orthogonale au premier axe X, chaque vis 102 étant associée à l'un des orifices d'accès 101. De tels moyens étant bien connus de l'art antérieur ils ne seront pas détaillés ici.

En ce qui concerne l'obturateur 1, les broches 6, 7 sont simplement dimensionnées pour être d'une longueur suffisamment importante pour pouvoir passer sous les moyens de verrouillage et être verrouillées par eux dans le boitier 100 en place des extrémités de câble.

On retient ainsi que l'obturateur 1 est avantageusement maintenu en place dans le boitier 100 dans sa première position par des moyens déjà présents dans le boitier 100. L'utilisation de l'obturateur 1 ne nécessite donc aucun moyen de verrouillage dédié tel que par exemple des moyens de clipsage.

Si maintenant un opérateur souhaite raccorder des extrémités de câbles au boitier, il va simplement agir sur les moyens de verrouillage pour libérer l'obturateur 1. Puis il retourne l'obturateur 1 afin que chaque orifice d'accès 101 du boitier se retrouve aligné coaxialement avec l'une des ouvertures 11, 12 de l'obturateur 1. Il insère alors une extrémité de câble dans chaque ouverture 11, 12 puis dans chaque orifice d'accès 101 correspondant avant d'agir classiquement sur les moyens de verrouillage pour maintenir en place l'extrémité de câble dans le boitier 100. Ceci permet également à la fois de maintenir en place l'obturateur 1 dans sa deuxième position.

On retient ainsi que là encore l'obturateur 1 est avantageusement maintenu en place dans le boitier 100 dans sa deuxième position par des moyens déjà présents dans le boitier. L'utilisation de l'obturateur 1 ne nécessite donc aucun moyen de verrouillage dédié tels que par exemple des moyens de clipsage.

Dans la deuxième position, la deuxième face principale 4 de l'obturateur est alors tournée vers le boitier 100 et la première face principale 3 vers l'extérieur du boitier 100.

Dans les faits, l'opérateur dénude le câble pour n'insérer dans l'ouverture puis l'orifice d'accès que l'âme conductrice 103 du câble.

Chaque ouverture 11, 12 est donc conformée pour présenter un diamètre supérieur ou égal à celui de l'âme conductrice 102 du câble. Par ailleurs, chaque ouverture 11, 12 est conformée pour présenter, au moins au niveau de la première face principale 3, un diamètre strictement inférieur à celui de l'extrémité de câble non dénudée soit le diamètre combiné de celui de l'âme conductrice 103 et de la gaine isolante 104 du câble.

De la sorte, seule l'âme conductrice 103 pénètre dans l'ouverture considérée de l'obturateur 1 alors que la gaine isolante 104 se retrouve en butée contre la première face principale 3.

Ceci permet de mieux maintenir en place l'obturateur 1 dans le boitier, lorsque l'obturateur 1 est dans sa deuxième position, et ce toujours sans avoir à ajouter des moyens supplémentaires au boitier 100 existant. En effet, l'obturateur 1 se retrouve alors bloqué entre la gaine isolante 104 et le boitier 100.

Par ailleurs la gaine isolante 104 borde alors extérieurement les ouvertures ce qui permet de protéger le boitier 100 de l'environnement extérieur.

Par ailleurs, dans cette deuxième position, les brides 14, 15 se retrouvent également en butée contre le boitier 100 de sorte à border extérieurement les orifices d'accès 101. Ceci permet encore davantage de protéger le boitier 100 de l'environnement extérieur.

Ainsi, avec une seule pièce qu'est l'obturateur 1 il est possible tout à la fois :
- de boucher les orifices d'accès 101 lorsqu'ils ne sont pas utilisés pour un ou des raccordements,
- de permettre le raccordement des extrémités de câbles en temps voulu.

Plus précisément ici, l'obturateur 1 permet :
- dans sa première position d'obstruer complètement de l'extérieur les orifices d'accès 101 à lui seul,
- dans sa deuxième position d'obstruer complètement de l'extérieur les orifices d'accès 104 avec l'aide des câbles de raccordement.

L'obturateur 1 permet donc de masquer les orifices d'accès 101 dans ses deux positions.

L'obturateur 1 protège ainsi particulièrement bien le boitier de l'environnement extérieur (nuisibles, poussières, conditions météorologiques exigeantes telles que brouillard salin ...) .

Bien entendu l'invention n'est pas limitée au mode de réalisation décrit et on peut y apporter des variantes sans sortir du cadre de l'invention tel que défini par les revendications.

En particulier, bien qu'ici le boîtier soit un compteur électrique, le boîtier pourra être différent et être par exemple un boîtier électronique, un boîtier électrique ... Le boitier pourra par exemple être un boîtier de commande d'un portail d'une habitation.

L'obturateur pourra bien entendu avoir une autre forme que celle indiquée. L'obturateur pourra par exemple présenter une section transversale circulaire et non carré ou rectangulaire. Le ou les ouvertures de l'obturateur pourront être conformées en cylindre et non en tronc de cône. La ou les broches pourront avoir une autre forme que ce qui a été décrit et par exemple présenter un seul tronçon de même diamètre. L'obturateur pourra comporter une ou des brides de forme différente de ce qui a été proposé. La ou les broches et/ou la ou les brides pourront être agencées de manière inclinée vis-à-vis des faces principales de la base et non à la normale comme ce qui a été indiqué ici. Bien qu'ici la première face et la deuxième face de l'obturateur ne soit pas plaquée contre le boitier (respectivement dans la première position de l'obturateur et dans la deuxième position de l'obturateur), ladite première face et/ou ladite deuxième face pourra être plaquée contre le boitier. Le boitier pourra ou non comporter un logement pour la réception de l'obturateur. L'obturateur pourra comporter un ou des moyens de fermeture temporaire d'au moins l'une de ses ouvertures pour le cas où l'opérateur n'a pas besoin d'insérer une extrémité de câble dans chaque ouverture de l'obturateur comme par exemple un volet sécable.

Bien qu'ici seule l'âme conductrice du câble soit insérée dans l'ouverture de l'obturateur, tout le câble (i.e. l'âme conductrice et la gaine isolante) pourra être inséré dans ladite ouverture. En variante, tout le câble (i.e. l'âme conductrice et la gaine isolante) pourra être inséré dans ladite ouverture sur une partie seulement de ladite ouverture puis seule l'âme conductrice continuera de s'étendre à travers le reste de l'obturateur.

La broche pourra être agencée entièrement à l'intérieur de l'orifice d'accès dans la première position de l'obturateur (et non partiellement comme ce qui a été illustré ici). La bride pourra être agencée partiellement ou entièrement à l'intérieur de l'orifice d'accès dans la deuxième position de l'obturateur (et non extérieurement comme ce qui a été illustré ici).

## Revendications

1. Obturateur pour boîtier destiné à recevoir au moins une extrémité de câble, l'obturateur comprenant au moins :
- une broche (6, 7) destinée à, dans un premier sens d'utilisation de l'obturateur, boucher un orifice d'accès à l'intérieur du boîtier, et
- une ouverture (11, 12) destinée à, dans un deuxième sens d'utilisation de l'obturateur, coopérer avec l'orifice d'accès pour permettre à au moins une âme conductrice d'une extrémité de câble de s'étendre en service à travers l'ouverture et l'orifice afin de pénétrer à l'intérieur du boîtier ;
**caractérisé en ce que**
l'obturateur comprenant en outre une bride (14, 15) associée à l'ouverture.

2. Obturateur selon la revendication 1, dans lequel la broche (6, 7) est venue de matière avec une base (2) de l'obturateur.

3. Obturateur selon la revendication 1 ou la revendication 2, dans lequel la broche (6, 7) s'étend à partir d'un des coins de l'obturateur et/ou l'ouverture est ménagée dans l'un des coins de l'obturateur.

4. Obturateur selon la revendication 3, dans lequel la broche (6, 7) s'étend à partir d'un premier coin de l'obturateur et l'ouverture (11, 12) est ménagée dans un deuxième coin de l'obturateur différent du premier coin.

5. Obturateur selon l'une des revendications 1 à 4, dans lequel la broche (6, 7) comporte au moins deux tronçons dont l'un est d'un diamètre supérieur à l'autre.

6. Obturateur selon la revendication 5, dans lequel le tronçon de plus gros diamètre est conformé pour présenter un diamètre supérieur à celui de l'orifice d'accès associé.

7. Obturateur selon l'une des revendications 1 à 6, dans lequel l'ouverture (11, 12) est conformée en un tronc de cône se rétrécissant en direction d'une face de l'obturateur portant la broche.

8. Obturateur selon l'une des revendications 1 à 7, dans lequel au moins un tronçon de l'ouverture présente un diamètre supérieur à celui d'une extrémité de câble.

9. Obturateur selon l'une des revendications 1 à 8, dans lequel la bride est ouverte sur au moins une partie de sa périphérie.

10. Obturateur selon l'une des revendications 1 à 9, dans lequel la bride est conformée pour présenter, au moins à son extrémité libre, un diamètre supérieur à celui de l'orifice d'accès.

11. Obturateur selon l'une des revendications 1 à 10, comportant au moins :
- deux broches (6, 7) destinées à, dans un premier sens d'utilisation de l'obturateur, boucher l'un respectifs des orifices d'accès à l'intérieur du boîtier, et
- deux ouvertures (11, 12) destinées à, dans un deuxième sens d'utilisation de l'obturateur, coopérer avec les orifices d'accès pour permettre à au moins une extrémité de câble de s'étendre en service à travers l'une des ouvertures et l'orifice associé afin de pénétrer à l'intérieur du boîtier.

12. Boitier comprenant au moins un orifice d'accès à l'intérieur du boitier, le boitier comprenant un obturateur selon l'une des revendications 1 à 11 lié audit orifice d'accès.

13. Boitier selon la revendication 12, dans lequel le boîtier est un compteur électrique.

14. Boitier selon la revendication 12 ou la revendication 13, comprenant au moins un moyen de verrouillage de l'âme conductrice dans le boitier lorsque l'obturateur est dans sa deuxième position et qu'une extrémité de câble est raccordé au boitier, l'obturateur (1) étant conformé de sorte que dans sa première position le moyen de verrouillage coopère avec la broche pour maintenir l'obturateur en position.

## Patentansprüche

1. Verschluss für ein Gehäuse, das dazu bestimmt ist, mindestens ein Kabelende aufzunehmen, wobei der Verschluss mindestens umfasst:
- einen Stift (6, 7), der dazu bestimmt ist, in einer ersten Verwendungsrichtung des Verschlusses ein Zugangsloch zum Inneren des Gehäuses zu verschließen, und
- eine Öffnung (11, 12), die dazu bestimmt ist, in einer zweiten Verwendungsrichtung des Verschlusses mit dem Zugangsloch zusammenzuwirken, um mindestens einer leitenden Seele eines Kabelendes zu ermöglichen, sich im Gebrauch durch die Öffnung und das Loch zu erstrecken, um ins Innere des Gehäuses einzudringen;
**dadurch gekennzeichnet, dass** der Verschluss ferner einen mit der Öffnung verbundenen Flansch (14, 15) umfasst.

2. Verschluss nach Anspruch 1, bei dem der Stift (6, 7) einstückig mit einer Basis (2) des Verschlusses ausgebildet ist.

3. Verschluss nach Anspruch 1 oder Anspruch 2, bei dem sich der Stift (6, 7) von einer der Ecken des Verschlusses aus erstreckt und/oder die Öffnung in einer der Ecken des Verschlusses ausgebildet ist.

4. Verschluss nach Anspruch 3, bei dem sich der Stift (6, 7) von einer ersten Ecke des Verschlusses aus erstreckt und die Öffnung (11, 12) in einer zweiten Ecke des Verschlusses ausgebildet ist, die sich von der ersten Ecke unterscheidet.

5. Verschluss nach einem der Ansprüche 1 bis 4, bei dem der Stift (6, 7) mindestens zwei Abschnitte umfasst, von denen einer einen Durchmesser hat, der größer als der andere ist.

6. Verschluss nach Anspruch 5, bei dem der Abschnitt mit dem größeren Durchmesser so geformt ist, dass er einen Durchmesser aufweist, der größer als der des dazugehörigen Zugangsloches ist.

7. Verschluss nach einem der Ansprüche 1 bis 6, bei dem die Öffnung (11, 12) zu einem Kegelstumpf geformt ist, der sich in Richtung einer Seite des Verschlusses, die den Stift trägt, verjüngt.

8. Verschluss nach einem der Ansprüche 1 bis 7, bei dem mindestens ein Abschnitt der Öffnung einen Durchmesser aufweist, der größer als der eines Kabelendes ist.

9. Verschluss nach einem der Ansprüche 1 bis 8, bei dem der Flansch auf mindestens einem Teil seines Umfangs offen ist.

10. Verschluss nach einem der Ansprüche 1 bis 9, bei dem der Flansch so geformt ist, dass er mindestens an seinem freien Ende einen Durchmesser aufweist, der größer als der des Zugangsloches ist.

11. Verschluss nach einem der Ansprüche 1 bis 10, mindestens umfassend:
- zwei Stifte (6, 7), die dazu bestimmt sind, in einer ersten Verwendungsrichtung des Verschlusses jeweils eines der Zugangslöcher zum Inneren des Gehäuses zu verschließen, und
- zwei Öffnungen (11, 12), die dazu bestimmt sind, in einer zweiten Verwendungsrichtung des Verschlusses, mit den Zugangslöchern zusammenzuwirken, um mindestens einem Kabelende zu ermöglichen, sich im Gebrauch durch eine der Öffnungen und das dazugehörige Loch zu erstrecken, um ins Innere des Gehäuses einzudringen.

12. Gehäuse, umfassend mindestens ein Zugangsloch zum Inneren des Gehäuses, wobei das Gehäuse einen Verschluss nach einem der Ansprüche 1 bis 11 umfasst, der mit dem genannten Zugangsloch verbunden ist.

13. Gehäuse nach Anspruch 12, bei dem das Gehäuse ein Stromzähler ist.

14. Gehäuse nach Anspruch 12 oder Anspruch 13, umfassend mindestens ein Verriegelungsmittel zur Verriegelung der leitenden Seele in dem Gehäuse, wenn der Verschluss in seiner zweiten Position ist und wenn ein Kabelende mit dem Gehäuse verbunden ist, wobei der Verschluss (1) derart geformt ist, dass in der ersten Position des Verschlusses das Verriegelungsmittel mit dem Stift zusammenwirkt, um den Verschluss in Position zu halten.

## Claims

1. A shutter for a housing intended to accommodate at least one cable end, the shutter comprising at least:
- a pin (6, 7) intended, along a first direction of use of the shutter, to plug an access port inside the housing, and
- an opening (11, 12) intended, along a second direction of use of the shutter, to cooperate with the access port in order to allow at least one conductive core of a cable end to extend through the opening and the port in use in order to penetrate inside the housing;
**characterised in that**
the shutter further comprising a flange (14, 15) associated with the opening.

2. The shutter according to claim 1, wherein the pin (6, 7) is formed integrally with a base (2) of the shutter.

3. The shutter according to claim 1 or claim 2, wherein the pin (6, 7) extends from one of the corners of the shutter and/or the opening is arranged in one of the corners of the shutter.

4. The shutter according to claim 3, wherein the pin (6, 7) extends from a first corner of the shutter and the opening (11, 12) is arranged in a second corner of the shutter different from the first corner.

5. The shutter according to any one of claims 1 to 4, wherein the pin (6, 7) includes at least two sections, one of which has a larger diameter than the other.

6. The shutter according to claim 5, wherein the larger-diameter section is shaped to have a diameter that is greater than the diameter of the associated access port.

7. The shutter according to any one of claims 1 to 6, wherein the opening (11, 12) is shaped as a truncated cone tapering towards a face of the shutter carrying the pin.

8. The shutter according to any one of claims 1 to 7, wherein at least one section of the opening has a diameter greater than that of a cable end.

9. The shutter according to any one of claims 1 to 8, wherein the flange is open over at least one portion of its periphery.

10. The shutter according to any one of claims 1 to 9, wherein the flange is shaped to present, at least at its free end, a diameter that is greater than that of the access port.

11. The shutter according to any one of claims 1 to 10, comprising at least:
- two pins (6, 7) intended, along a first direction of use of the shutter, to plug a respective one of the access ports inside the housing, and
- two openings (11, 12) intended, along a second direction of use of the shutter, to cooperate with the access ports in order to allow at least one cable end to extend through one of the openings and the associated ports in use in order to penetrate inside the housing.

12. A housing comprising at least one access port inside the housing, the housing comprising a shutter according to any one of claims 1 to 11 connected to said access port.

13. The housing according to claim 12, wherein the housing is an electric meter.

14. The housing according to claim 12 or claim 13, comprising at least one means to lock the conductive core in the housing when the shutter is in its second position and an end of the cable is connected to the housing, the shutter (1) being shaped so that in its first position, the locking means co-operates with the pin to hold the shutter in position.
